# EUROPEAN PATENT APPLICATION

(11) **EP 1 367 668 A1**
(43) Date of publication of application: **03.12.2003**
(21) Application number: 02425349.4
(22) Date of filing: 30.05.2002
(51) Int. Cl.: H01P 5/107, H01Q 13/02

(54) **Broadband microstrip to waveguide transition on a multilayer printed circuit board**

(71) Applicant: Siemens Information and Communication Networks S.p.A., 20126 Milano (IT)
(72) Inventor: Buoli, Carlo, 20060 Bussero (IT); Bonzi, Aldo, 20025 Legnano (IT); Gadaleta, Vito Marco, 70126 Bari (IT); Turillo, Tommaso, 20063 Cernusco sul Naviglio (IT); Zingirian, Alessandro, 16145 Genova (IT)
(74) Representative: Giustini, Delio

(57) **Abstract**

A microstrip to waveguide broadband transition is manufactured together with a multilayer printed circuit board arranged for operating in the microwaves. The first dielectric substrate (diel1) of the multilayer supports a metallic layout (met1) of a planar circuit including a microstrip (15) which has to be coupled to a rectangular waveguide (20) for transmitting/receiving a microwave signal to/from the external of the board. The second layer is a metal plate (met2) having thickness such as to offer mechanical stiffness to the first dielectric substrate (diel1) adherent to it. The metal plate constitutes an electrical grounding plane enabling the conductive lines of the upper metallic layout (met1 ) to operate as microstrips, and further dissipates the heat of the MMIC components placed on it. A first slot (18) is milled in the thick metal plate (met2) in correspondence of the end of the microstrip (15) shaped as a patch (16). The first slot (18) having shape and dimensions calculated to act in the desired frequency band as a transition from the electromagnetic propagation mode of the relevant microstrip (15) to the propagation mode of the waveguide (20). The multilayer (diel2, diel3) is milled up to the thick metal plate (met2) all around the first slot (18), and the bare metal surface is smoothed and cleaned to make it as a flange ready to be screwed to the end of the rectangular waveguide (20). A waveguide transformer maximises the electromagnetic energy transfer through the first slot (18) to the waveguide (20). The waveguide transformer includes an initial tract (19) of the first slot (18) milled for widening the cross-section, and a second slot (20') opened in the end wall of the waveguide (20) having the same cross-section as said initial tract (19) of the first slot (18). An upper backshort (22) shield the zone of the transition. The waveguide is dug in the mechanics housing the board (fig.5c).

## Description

### FIELD OF THE INVENTION

The present invention refers to the microwave circuits and more precisely to a broadband microstrip to waveguide transition on multilayer printed circuit boards arranged for operating in the microwaves.

### BACKGROUND ART

The use in the field of the microwaves of low-cost substrates characterised by high dielectric losses, such as for instance those in fibre-glass reinforced plastic, also known as FR4, is described in the European Patent EP 992107 granted in the name of the same Applicant. In the specific case a 18 GHz VCO (Voltage Controlled Oscillator) has been implemented on the FR4 substrate. In particular, a 18 GHz signal was coupled to a not well specified matched load placed on the board near the VCO, leaving completely undisclosed the problem of how coupling to an external cable or a metallic guide the microwave signal travelling on a microstrip printed on the board.

The problem of how implementing a microstrip to waveguide transition is well known in the art of the microwave circuits laid down on the rigid alumina substrates, but is not as much adequately set in the art of the printed circuit board, mainly because of their typical application at lower frequencies which usually needn't guides. Considering for example a more general microwave circuit on alumina substrate which supports microstrips, the substrate shall be adequately metallized on both sides in order to obtain a real microstrip layout connectable to in-chip devices of MMIC (Monolithic Microwave Integrated Circuits) type. As a precautionary measure an assembled circuit on alumina substrate is generally enclosed in a metal case furnishing mechanical support and heat dissipation. The alumina substrate is glued to the metal case through a conductive resin applied on the ground plane, or welded. Coaxial cables or rectangular waveguides are fixed to the walls of the case for receiving, or transmitting, the microwave signals from/to relevant points of the microstrip layout. Sources are known from the microwave theory able to excite microwaves into waveguides; typical sources are: metallic probes or rings protruding into the cavity of the guide, or apertures into the walls of the guide. In correspondences of said exciting sources transitions between different propagation modes take place. A waveguide to microstrip transition typical for alumina substrates consists of a cylindrical body of Teflon ® crossed along the longitudinal axis by a metal pin which protrudes from the two ends (beam lead). The cylindrical body is partly inserted in a wall of a rectangular waveguide with the metal pin coming out in the recess of the guide as an antenna, while at the opposite side of the cylindrical body the metal pin is connected with the relevant microstrip. The connection is usually made through thin gold wires welded by thermal compression, this operation being called "bonding" or "thermobonding" and is generally performed manually. The indicated microstrip/guide transition is notoriously reciprocal (guide/microstrip).

The low dielectric losses of alumina substrates make them elective for obtaining microwave circuits of good quality, even at the highest frequencies, but their excessive hardness and fragility prevent the extension to the alumina of the automatic or semiautomatic assembly techniques already widely used in the manufacturing of the printed circuit boards. As far as concern mechanical limitations, for example, drilling needs laser or ultrasonic drills, and screws are not usable for fixing the substrates. The above description of a microstrip to waveguide transition of probe type, more suitable to the alumina substrates than those of slot-excited type, is a clear example of how the full automation of the manufacturing process is prevented from the manual operations needed to obtain the transition.

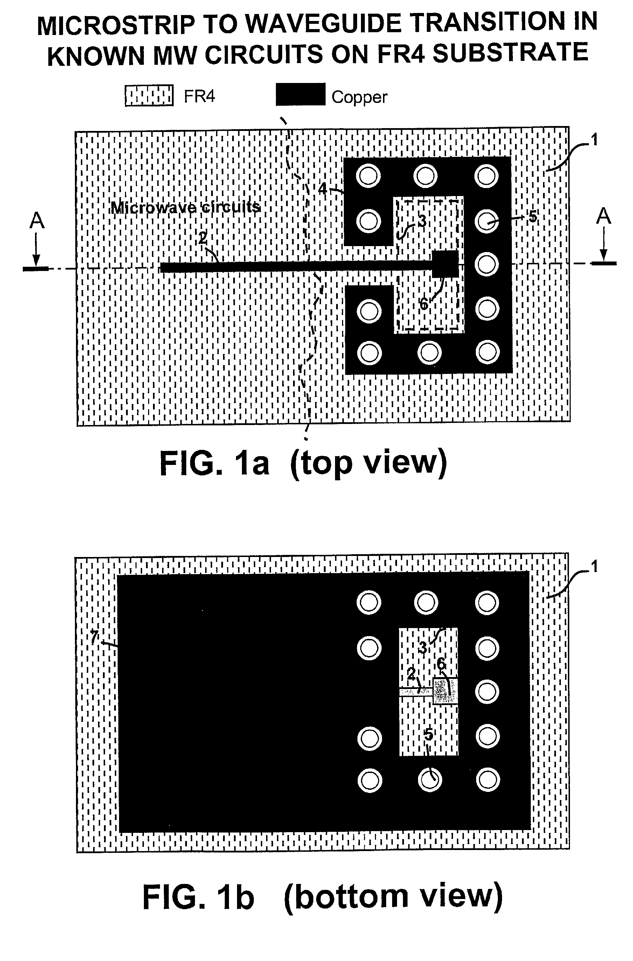

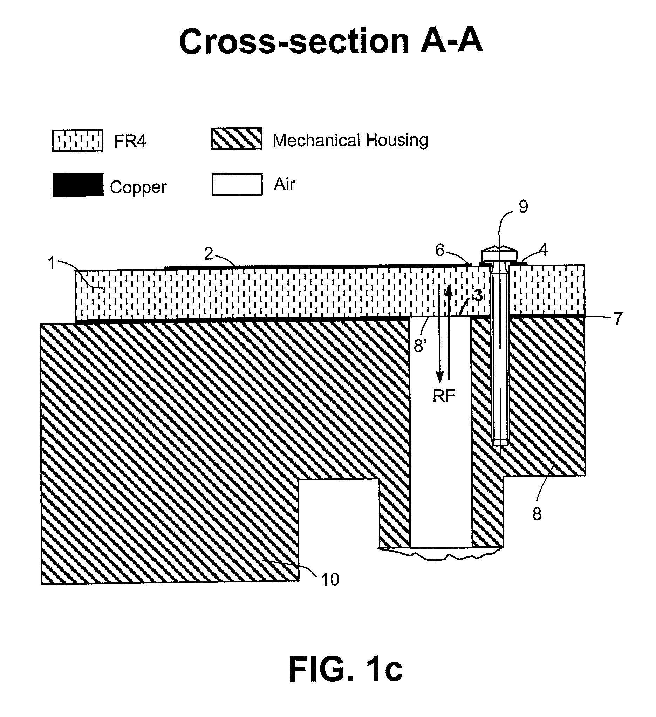

The FR4 substrates are suitable for automated surface mounting and to not suffer by most of the mechanical limitations of the alumina substrates but their high losses, a little bit more than 1 dB for wavelength, and the impossibility to dissipate thermal power in the fastening area of high power chips, prevent a satisfactorily extension to the microwaves circuits other than the ones having characteristics as similar as the VCO of the above mentioned invention. The use of FR4 substrate is therefore presently limited to circuits crossed by scarce electric power in which the path covered by the microwave signal was reduced to the minimum extent. Notwithstanding these measures, the maximum operation frequency does not exceed 18 GHz. Since in the technique of telecommunication equipment we assist to a continuous shifting of frequency limits (at present over 50 GHz), considering the need to amplify the signals be transmitted, and the fact that it is not always possible to minimise the length of microstrips, we can say that the usual realisation techniques of microwave circuits based on alumina substrates enclosed in metallic housing connected to waveguides or cables are still dominant. As already said the problem of realising a microstrip to waveguide transition in the FR4 substrate has not been discussed in said previous patent, but a well conjecturable transition of the slot-excited type should be like the one depicted in **Figure 1a, 1b** and **1c**.

**Fig.1a** is a top view of a printed circuit board on FR4 substrate 1 that includes microwave circuits, not fully indicated for the sake of simplicity. Microwave circuits (at the left side of the Figure) are connected to a microstrip line 2 which conveys a microwave signal towards a rectangular zone 3 (hatched) delimited by a perimetral metallization 4 interrupted in correspondence of the microstrip 2. Perimetral holes 5 are drilled in the layer 1 in correspondence of the perimetral metallization 4. Inside the zone 3 the microstrip 2 ends with a metal patch 6 spaced out the metallization 4.

**Fig.1b** is a bottom view of the printed circuit board of fig.1 showing a ground plane 7 without metallization in correspondence of the rectangular zone 3. The metal patch 6 and the portion of the microstrip 2 protruding in the rectangular zone 3 on the upper face are also visible in the bottom view due to the semitransparent FR4 layer.

**Fig.1c** is a cross-section along the axis A-A of **fig.1a**. The Figure shows a metallic waveguide 8 placed on the bottom side of the board and fixed to the layer 1 by means of metallic screws 9 penetrating into the holes 5 (fig.1a). The end of the rectangular waveguide 8 has an opening 8' of the same dimension of the rectangular zone 3 without metallization on the ground plane. The resulting structure is further connected to a mechanical housing 10, closed in the top if necessary. In the operation, the end of the upper microstrip 2 connected to the terminal metal patch 6, the rectangular zone 3 without metallization on the ground plane, and the corresponding opening 8' in the waveguide 8, constitute a microstrip to waveguide transition that transforms the "quasi-TEM" propagation mode of the microstrip 2 into the TE10 mode of the rectangular waveguide 8. The electromagnetic properties of the transition are reciprocal, so that the same structure used by the RF transmitter for conveying inside the waveguide 8 a transmission signal from the microstrip 2 is also used by the receiver for conveying a RF reception signal from the waveguide 8 to the microstrip 2. With reference to the **Fig.1c** the thickness of the various layers are typically 18 µm for the various metallization 2, 4, 6 and 7, and about 300 µm for the FR4 substrate 1. The intrinsic flexibility of the little thickness FR4 substrate 1 makes the resulting printed board quite flexible and difficult to be satisfactorily connected to the metallic waveguide 8. That because the unavoidable mechanical vibrations of a not sufficiently rigid structure can significantly alter the impedance matching of the microwave signal crossing the transition and consequently worsen the propagation. Furthermore, if the dielectric substrate has not a good contact with the mechanical guide, or the case, it happens that waveguide and microstrip have different electrical grounds so that mismatching, unwanted resonances, and radiation losses take place. The most known connecting means are by screwing and by gluing. The first one has the drawback that a lot of little holes (5) for as many little screws 9 are needed, in order to prevent any mechanical deformations of the substrate 1 in correspondence of the perimetral metallization 4 surrounding the transition. The connection by gluing is not so reliable as by screwing, because the vibrations can long-term detach the flexible printed board away from the waveguide 8. Besides a smear of glue into the zone of the transition can alter the optimal propagation. In that it has been proved that also the manufacture of slot-excited transitions in VCO's type printed circuit boards arranged for operating in the microwaves suffers the drawbacks of requesting precise manual operations for fixing the waveguide. Transitions based on a metallic probe protruding inside a rectangular waveguide mounted on the FR4 substrate intrinsically require the manual operations of mounting the probe and bonding it to the microstrip.

### OBJECTS OF THE INVENTION

The main object of the present invention is to overcome the drawbacks of the known art towards a more complete automation of the assembly of printed circuit boards supporting planar microwave circuits connected to a waveguide by means of a slot-excited transition.

### SUMMARY AND ADVANTAGES OF THE INVENTION

In order to meet those requirements the subject of the present invention is a manufacturing method of a microstrip to waveguide transition on a printed circuit board arranged for operating in the microwaves is claimed, as disclosed in claim 1.

According to the method of the invention, the provision of a thick metal plate (copper) placed immediately under the upper metallized dielectric layer simultaneously achieves: **a)** an electrical ground plane enabling the conductive lines of the uppermost planar circuit on FR4 to operate as microstrips; **b)** a heat dissipating support for the MMIC circuits directly glued on the thick copper plate through opportune openings of the first FR4 layer; **c)** a support sufficiently rigid to greatly simplify the manual step for the connection of the waveguide to the printed circuit board in the zone of the transition. The third advantage c) is due to the fact that only four screws of usual dimension are needed to fix the waveguide directly to the thick copper plate (by milling the lower FR4 layers in that part) instead of a lot of little screws 9 (figures 1a-c). The nude copper plate in the zone around the transition acts as a flange for fastening the rectangular waveguide, in that it provides a connection which is able to prevent any mechanical deformations of the substrate in the zone of the transition due to the unavoidable mechanical vibrations. In the following the term "flange" is intended with the meaning given above. Besides the position of the flange as second layer of the multilayer makes itself part of the transition, so that is possible milling it around the slot in order to match the slot to the waveguide impedance.

it's useful point out that with any position of the thick metallic plate in the multilayer other than the second one, the underlined advantages shouldn't be simultaneously obtainable. In particular if the thick metallic plate were placed at the bottom position in thermal contact with a microwave chip on it, each path covered by the microwave signal from the internal of the chip to the point of connection with an on top microstrip should be lengthened in respect of the solution of the present invention. That because the signal shall cover the length of the multilayer thickness plus the length of the bonding before reaching the microstrip, and the impedance of the covered path is mismatched. As previously pointed out discussing the VCO related invention, the path covered by the microwave signal must be reduced to the minimum extent in order to not reduce the frequency operating range. In the hypothetical discussed case an additional drawback is that the connections to ground of the microwave chip should be performed through long metallized holes, which notoriously are affected by induction effects that further limit the maximum operation frequency. Besides, the exploitation of the bottom thick metallic plate in order to obtain part of a waveguide transformer introduces unacceptable losses for the transition due to all the FR4's layers above it.

Other subject of the invention is a microstrip to waveguide transition manufactured in accordance with the claimed method, as disclosed in the relevant independent device claim.

### BRIEF DESCRIPTION OF THE DRAWINGS

The features of the present invention which are considered to be novel are set forth with particularity in the appended claims. The invention, together with further objects and advantages thereof, may be understood with reference to the following detailed description of an embodiment thereof taken in conjunction with the accompanying drawings given for purely non-limiting explanatory purposes and wherein:
- **Figures 1a, 1b** and **1c**, already discussed, show a possible solution for realising a microstrip to waveguide transition in a printed circuit board arranged for operating in the microwaves in accordance with the known art;
- **Figures 2, 3** and **4** show more advanced multilayer substrates of a printed circuit board arranged for operating in the microwaves;
- **Figures 5a, 5b** and **5c**, show a microstrip to waveguide transition in the advanced multilayer substrates manufactured with the method of the present invention;
- **Figures 6a** and **6b** show the frequency response of parameters characterising the microstrip to waveguide transition of Figures 5a-c.

### DETAILED DESCRIPTION OF AN EMBODIMENT OF THE INVENTION

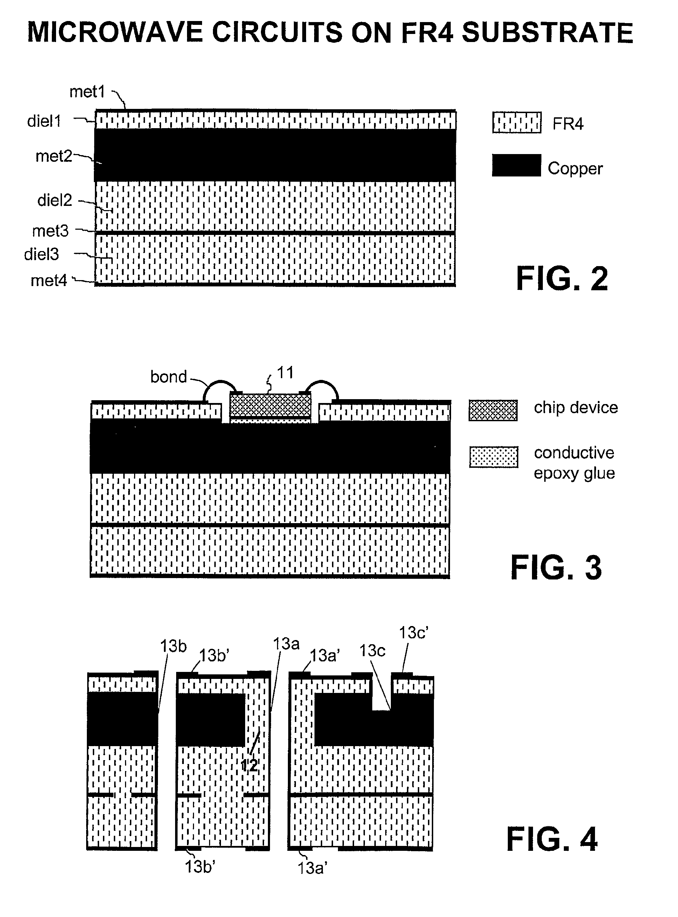

In the several figures like referenced numerals identify like elements. With reference to **fig.2** it can be noticed a structure consisting of the following layers each other superimposed and listed top to bottom as: met1, diel1, met2, diel2, met3, diel3, and met4. The layers met1, met2, met3, and met4 are metal layers, preferably copper made, while the remaining layers correspond to FR4 substrates. As already said the FR4 or "vetronite"™ is a material made of glass fibres impregnated with epoxy resin. The vetronite is characterised by a tan δ value from 0,025 to 0,05, which configures it as suitable to the application in the printed circuits sector, but not immediately in that of microwave circuits, where alumina imposes with a tan δ = 0,0001. More in detail, the dielectric layer diel1 has 100 µm thickness, while the layers diel2 and diel3 have each a thickness of 300 µm. The layer met1 is referred to a layout placed on the front side of the layer diel1 and includes some microstrips. The layer met2 consists of a copper plate having opportune thickness, for instance 1 mm. The layer met3 is referred to an intermediate layout placed on one face of the board diel3, on the other face of which the layer met4 corresponds to a grounding plane. With the details supplied, the layer diel2 has the sole function to isolate the layout met3 (placed on the adjacent layer diel3) from the thick copper plate met2. An equivalent implementation is obtained placing the layout met3 on the surface of the layer diel2 not in contact with the copper plate met2. The techniques to obtain a multilayer starting from single metallized dielectric boards are known in the art of the printed circuits. Standards on printed circuits impose metal lines having width W not lower than 200 µm. The implementation of a microstrip on the layer met1 requires that the width W of the conductive lines and thickness h of the interposed layer diel1 are dimensioned to enable the propagation of a quasi-TEM mode in the dielectric strip included between the copper plate met2 and the line standing above. This occurs when the wavelength λ of the propagating microwave signal is far higher than the microstrip width. A ratio of approximately 10 between λ and W is to be considered as reasonable. Starting from a width W of 200 µm for the microstrips, we have only to find the thickness h enabling to reach the characteristic impedance of 50 Ω. The above mentioned thickness h resulted to be 100 µm, just as that indicated for the dielectric layer diel1. With a width W of 200 µm, the ratio λ/W = 10 involves a signal frequency of approximately 80 GHz. At equal characteristic impedance, higher widths W involve also higher thickness h and lower frequencies of the signal propagating along the microstrip. Concerning the attenuation suffered by the signal, it is a little bit higher than 1 dB over a distance of one wavelength. In some applications, this attenuation does not represent a great problem if the extension of the networks is minimised.

With reference to **fig.3**, it can be noticed a microwave component 11 installed on the multilayer indicated in the previous **fig.2**. To this purpose, the first dielectric layer diel1 shows an appropriate opening for the introduction of the component 11, which is glued to the thick copper plate met2 underlying by means of conductive resin. The subject component can be a device, or a circuit, a bare MMIC chip, or as an alternative a network on alumina; in all the cases a ground plane is foreseen on the lower surface of the component 11. It can be appreciated how this type of fastening enables the realisation of a best connection to ground of the component 11, directly made on the copper plate met2, which in its turn shall be connected to the mechanical part along one free edge of the underlying lamination. It is thus avoided the connection to ground of the microwave components through metallized holes, that occurred on the contrary in the VCO of the known art, eliminating the induction effects of a so-called hot mass that limits the maximum operation frequency. The connection of the supplies to the chip 11 and the application of relevant input/output signals are made by thermobonding. To maintain the chip input and output impedance at 50 Ω it is necessary that the relevant connections are extremely short; this is possible if the thickness of the first dielectric layer diel1 can be compared to that of the bare chip, as it results in fact for the thickness of 100 µm adopted for the layer diel1. In the practice, it is convenient to cover the chips and the connection gold wires with an adequate protection resin of the marketable type.

**Fig.4** shows metallized holes 13a and 13b (via-hole) crossing the multilayer of fig.3 to implement a connection between the conductive lines of the surface layout met1 and either a line of the intermediate layout met3 (13a) or the grounding metal plate met2 (13b) directly. A metallized blind hole 13c immediately terminating into the copper sheet met2 is also visible in the Figure. Hole 13c provides a short ground path with the layout met1. The intermediate layout met3 is profitably referred to the supply tracks of the active components on the front side, or to other low frequency networks, but it can also include striplines capable of conveying signals up to some Gigahertz. As it can be noticed, the metallization of holes 13a and 13b merges with that of opportune circular crowns 13a', 13b' and 13c' surrounding the holes on the various substrates. To avoid a short circuit to ground of the uppermost layout connected to the hole 13a the copper sheet met2 has a hole 12 having diameter higher than that of hole 13a. Circular areas without metallization are provided in the grounding plane met4 for including the hole 13a and the circular crown 13a'. Of course, the holes 12 shall always be made before the stacking of the copper sheet met2 within the multilayer, in order that said holes can be filled with the resinous material (prepreg) used to glue the layers each other, this material showing electrical characteristics very similar to the FR4.

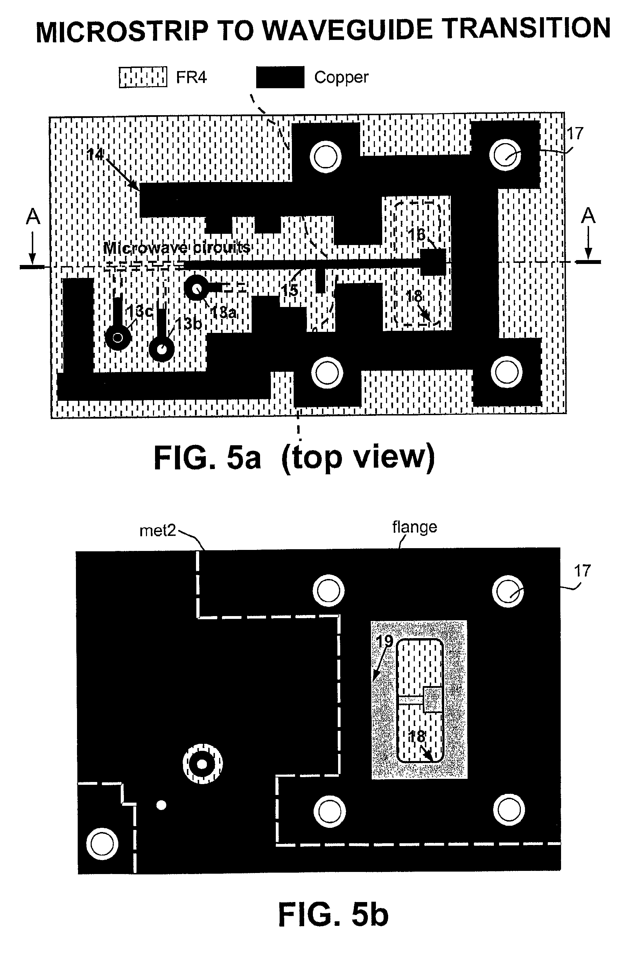

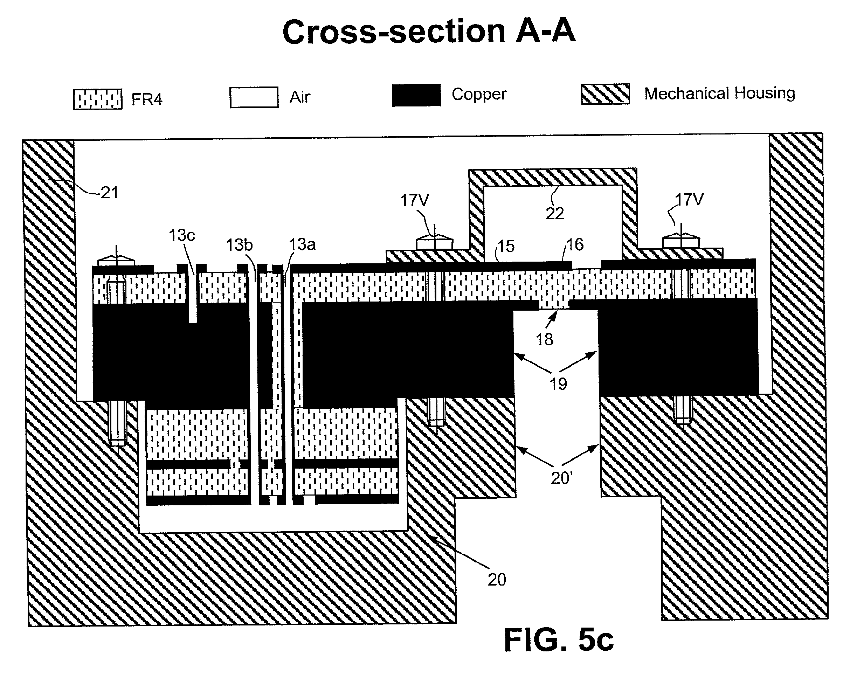

**Figures 5a, 5b** and **5c** extend the multilayer of the **Figures 2, 3,** and **4** in the zone of the transition. With reference to **Fig.5a** a superficial shielding metallization 14 belonging to the upper metal layer met1 is visible. The right side of the metallization 14 resembles a rectangular crown which contains a rectangular zone without metallization housing the end of a microstrip 15 terminating with a metal patch 16, separated from the crown. The microstrip 15 is laid down along the symmetrical axis **A-A** parallel to the shorter side of the rectangular zone without metallization inside the crown. At the corner of the rectangular crown four holes 17 are drilled in the multilayer for as many screws fixing a rectangular waveguide to the backside. The left side of the metallization 14 surrounds the remaining part of the microstrip 15 connected to a generic microstrip layout, and also surrounds the two via-holes 13a and 13b (fig.4) and the blind hole 13c. Inside the rectangular zone without metallization a dashed slot 18 (milled in the underneath thick metal plate met2) is indicated.

**Fig.5b** shows the down face of the thick metal layer met2 with the slot 18 placed at the centre of a rectangular zone 19 milled around it. The four threaded holes 17 for the waveguide, and the two via-holes 13a and 13b (fig.4) are also shown. The microstrip 15 terminating with the metal patch 16 laid down on the upper layer diel1 and protruding over the slot 18 are also visible in the figure, due to the semitransparent FR4 layer. The longer dashed line crossing the layer met2 indicates a right area constituting a flange for the head of the waveguide and a remaining area which shall be covered by the underneath multilayer. A shorter dashed line in the left corner indicates a milled area for the anchorage to the metal case.

**Fig.5c** is a cross-section along the axis A-A of **fig.5a**. The Figure shows the end of a rectangular metallic waveguide 20 in contact with the zone of the flange of the thick metallic layer met2. The end of the waveguide 20 is fixed to the upper layering comprising the layers met2 and diel1 by means of metallic screws 17V penetrating into the holes 17. The metallic walls of the end of the waveguide 20 has a rectangular opening 20' of the same shape and dimensions as the tract 19 milled around the slot 18 in the thick metal plate met2. In that the opening 20' and the contiguous tract 19 constitute an unique tract of the waveguide 20 at reduced cross-section prosecuting towards the slot 18 of the transition. At the boundary of the flange the further layers: diel2, met3, diel3, met4 (fig.2), and the two via-holes 13a and 13b (fig.4) are visible on the left. The waveguide 20, 20' is directly dug in a metal case 21 housing the multilayer. A metal backshort 22 is placed on the upper face of the board to cover the last part of the microstrip 15 and the metal patch 16. Backshort 22 is fixed to the multilayer by screws 17V penetrating two fins of the backshort drilled in correspondence of the holes 17. Backshort 22 is used as a reflector and to prevent the propagation on air.

In a first variant of the invention the waveguide 20 is fully open at the end.

In a second variant of the invention the cross-section of the tract 19 has a smaller area than the cross-area of the aperture 20' dug into the end wall of the waveguide 20.

In a third variant of the invention the tract 19 is not milled in the copper plate met2, and the cross-area of the aperture 20' either coincides with the cross-section of the slot 18 or is wider.

In a fourth variant of the invention the waveguide 20 is fully open at the end and the cross-area of the tract 19 coincides with the cross-section of the waveguide 20.

In a fifth variant of the invention the tract 19 is subdivided in two contiguous tracts in which the tract closer to the slot 18 has a cross-area smaller than the other tract.

In operation, the length and width of the slot 18 have to be chosen to make the transition working in the desired frequency band. In the present embodiment the frequency band is about 6 GHz wide from 27.5 to 33.5 GHz, so as to cover both the 27.5 - 29.5 GHz and 31.8 - 33.4 GHz operating bands. Relevant microwave theory for obtaining an overall equivalent circuit of the transition and calculating the proper dimensions of the aperture 18 has been widely developed in the specialised literature, for example in the following volumes:
- Robert E. Collin "Foundation for Microwave Engineering", McGraw-Hill International Edition. Chapter 5 - *Impedance transformation and matching.*
- G.L.Matthaei, L. Yong and E. M. T. Jones, "Microwave Filters, Impedance-Matching Networks, and Coupling Structures", Artech House Books, 1980. Chapter 6 - *Stepped-impedance transformers and filter prototypes.*

The underlined theory gives the guidelines to adequately arrange each tract of the transition to maximise the transfer of microwave power to an external load (not depicted in the Figures) over the desired frequency band. In particular:
- shape, position, and dimension of the patch 16 have to be chosen to match the coupling between the end of the microstrip 15 and the slot 18;
- the milled area 19 of the thick metal layer met2 that prosecutes in the opening 20' of the waveguide 20 constitute a unique tract of a rectangular waveguide acting as an impedance transformer to match the impedance of the slot 18 to the impedance of the waveguide 20.

As far as the realisation procedure of the printed circuit board connected to the waveguide 20 is concerned, it consists of some steps similar to those usually employed in the sector of printed circuits for the execution of a complex multilayer layout interconnected by via-holes. These steps, individually known, are interposed by other steps that are peculiar to the implementation of the subject invention, and therefore featuring it. That is the complete product is manufactured by the sequential steps of:
1. obtaining metallic layouts (by chemical attacking) and/or ground plane met3 and met4 on relevant faces of dielectric substrate diel3;
2. milling a slot 18 in a metal plate met2, preferably copper, having thickness such as to offer mechanical stiffness to an uppermost dielectric substrate diel1 when placed adherent to it. The slot 18 being milled in a zone corresponding to the end of a microstrip 15 which has to be obtained in a successive step with a layout met1 on the dielectric substrate diel1, in order to act as a transition for the electromagnetic energy from the relevant microstrip 15 to a cascaded rectangular waveguide 20;
3. drilling the thick metal plate met2 in first pre-determined points 12 sufficiently large to not short circuit to ground the via-hole connections 13a concentric to them;
4. spreading the surface of each internal layers with resinous material, called prepreg in the following, which shows electrical characteristics very similar to the material used for the dielectric substrates;
5. inserting the thick metal plate met2, as previously worked, between the first dielectric layer diel1 and the remaining multilayer consisting of an insulator layer diel2 and the metallized dielectric layer diel3;
6. hot-pressing the multilayer so obtained for gluing the layers each other and filling the slot 18 and the holes 12 with prepreg;
7. obtaining (by chemical attacking) the metallic layout met1 with the microstrip 15 on the front face of the upper dielectric substrate diel1; the microstrip 15 terminating with a patch 16 for either conveying a microwave signal towards the waveguide coupled to an external load, or receiving a microwave signal from the waveguide;
8. drilling through holes and metallizing them for obtaining the via-hole connections 13a, 13b and 13c;
9. milling the lower layers diel2 and diel3 up to the thick metal plate met2 in at least a zone around the slot 18 and smoothing and cleaning the metal surface to make it as a flange ready to be joined with the rectangular waveguide 20;
10. milling the thick metal plate met2 around the slot 18 for widening the cross-section of an initial tract 19 operating as a partial impedance transformer for matching the impedance of the slot 18 to the impedance of the waveguide 20;
11. milling the first dielectric layer diel1 for opening windows for the insertion of bare microwave chips metallized on the rear side;
12. fixing the bare microwave chips to the copper plate met2 by conductive glue;
13. bonding the above microwave chips to the upper layout met1;
14. optional covering the chip components and relevant bonds with a protection resin;
15. milling the end of the rectangular waveguide 20 for obtaining an opening 20' having the same cross-section as the tract 19 milled in the thick metal plate met2;
16. aligning the two openings 19 and 20' to complete the impedance transformer and fixing the end of the waveguide 20 to the upper flange on met2 by means of screws 17V, which also are fixing a metallic backshort 22 placed on the uppermost dielectric layer diel1 to cover and shielding the end of the microstrip 15 shaped as the patch 16;
17. and finally fixing and electrically grounding the multilayer to the housing mechanical part.

In case of not particularly complex circuits the invention can be implemented without the need to have recourse to a multilayer for the support of intermediate layouts. In that the constructional supports employed are the sole first dielectric layer diel1 and the thick copper sheet met2, and of course the mechanical part including waveguide 20. The sole necessary metallization is the surface layout met1 with the possible addition of short metallized holes for the connection of relevant points of the layout to the grounding plane, still consisting of copper met2. In the considered case the procedure according to the invention avails itself of the same steps simplified as follows:
1. suppressed;
2. idem; .
3. suppressed;
4. to a limited extent of the interface between the layers died and met2;
5. the thick metal plate met2 is placed underneath the dielectric layer diel1;
6. idem;
7. idem;
8. to a limited extent of blind holes like 13c;
9. suppressed;
10. idem;
11. idem;
12. - 14. if at least a bare microwave chip is present;
15. - 17. idem.

The described steps don't require critical processes and the transition is automatically achieved just screwing the board on the metal housing, without further operations like the beam-lead mounting and bonding. It can be appreciated that the zone which accommodates the slot 18 of the transition, thanks to the thick metal layer met2, is sufficiently rigid to avoid deformations. The microstrip to waveguide transition of the proposed embodiment shows very good performance in terms of bandwidth and low losses.

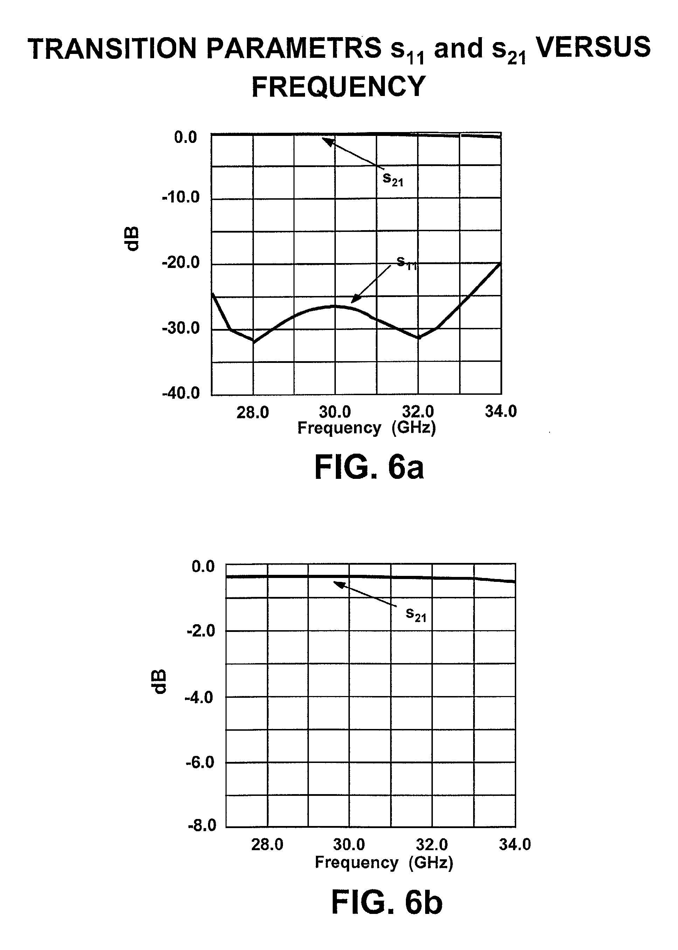

With reference to **fig.6a** the scattering matrix parameters **s**_{**11**} and **s**_{**21**} of the transition embodied as described with reference to the **Figures 5a, 5b, and 5c** is represented versus the frequency. The depicted results have been obtained with the following dimension for the slot 18: length 7.11 mm, width 1.4 mm, thickness 0.3 mm. The first tract of the waveguide transformer (19) has the following dimensions: length 7.1 mm, width 2 mm, thickness 0.6 mm. The second tract of the waveguide transformer (20') has the following dimensions: length 7.11 mm, width 2 mm, thickness 3 mm. The two curves have been obtained by known simulation techniques and confirmed by relevant measures. Parameter **s**_{**11**} represents the return loss at the input of the transition coinciding with the end of the microstrip 15, while **s**_{**21**} is the power transferred to a matched load. Fig.6b enlarges the detail of the parameter **s**_{**21**}. From the Figures is clearly visible that nearly 7 GHz bandwidth, from 27 to 34 GHz, is achievable with return losses lower than 20 dB and in-band attenuation lower than 0.5 dB. The good performance in term of bandwidth is almost 20% due to the waveguide transformer tract 19 and 20', part in the copper plate met2 and part in the waveguide 20.

The non-limiting embodiment of the transition can be easily extended to the use of waveguides having cross-section other than rectangular and dielectric substrates having the same mechanical characteristics as the FR4 but lower dielectric losses, such as for instance substrates known in the art with the commercial name ROGER^{TM}. Rectangular waveguides are preferable in respect of circular or elliptical waveguides, because easier to handle and dig in the metal body. When employing a circular or elliptical waveguide the shape and dimensions of slot 18 and the contiguous tracts 19 and 20' acting as waveguide transformer shall be calculated in accordance to the known theory for obtaining the relevant transition.

## Claims

1. Manufacturing method of a microstrip to waveguide transition on a printed circuit board that includes a first dielectric substrate (diel1) supporting a metallic layout (met1) belonging to a planar circuit on the front face including a microstrip (15) which has to be coupled to a waveguide (20) for transmitting/receiving a microwave signal to/from the external of the board, **characterised in that** includes the steps of:
- milling a first slot (18) in a metal plate (met2) having thickness such as to offer mechanical stiffness to the first dielectric substrate (diel1) when placed adherent to it, being the first slot (18) milled in correspondence of the end of said microstrip (15) with shape and dimensions calculated to act in the desired frequency band as a transition from the electromagnetic propagation mode of the relevant microstrip (15) to the propagation mode of the waveguide (20);
- fixing the metal plate (met2), preferably copper made, to the rear face of said first dielectric substrate (diel1) to obtain an electrical grounding plane enabling the conductive lines of said metallic layout (met1) to operate as microstrips;
- milling the end wall of the waveguide (20) for obtaining a second slot (20') having a cross-section wider than the one of the first slot (18);
- aligning the two slots (18, 20') to complete the transition and fixing by fastening means (17V) the end of the waveguide (20) to the thick metal plate (met2) acting as a flange.

2. Manufacturing method in accordance with claim 1, **characterised in that** the end of said microstrip (15) is shaped like a metal patch (16) whose dimensions are calculated to match the coupling between the end of the microstrip (15) and the first slot (18) milled in the thick metal plate (met2).

3. Manufacturing method in accordance with claim 1 or 2, **characterised in that** includes the additional steps of:
- milling the thick metal plate (met2) around the first slot (18) for widening the cross-section of an initial tract (19);
- milling the end wall of the rectangular waveguide (20) around the second slot (20') for widening the cross-section as the initial tract (19) of the first slot (18) so that the two contiguous slots (19, 20') operate as a waveguide transformer which improves the electromagnetic energy transfer from said microstrip (15) to the waveguide (20), or vice-versa, minimising the return losses.

4. Manufacturing method in accordance with one of the preceding claims, **characterised in that** includes the additional steps of:
- providing additional dielectric layers (diel2, diel3) supporting relevant circuit layouts or ground planes ((met3, met4);
- stacking the metallized dielectric layers (diel2, diel3) with said thick metal plate (met2) and the first dielectric substrate (diel1), and fixing each other the various layers for obtaining a multilayer printed circuit board;
- drilling holes (13a, 13b) through the multilayer and metallizing them for electrically connect relevant points of the various layouts or ground planes.

5. Manufacturing method in accordance with the preceding claim, **characterised in that** includes the additional step of milling the additional dielectric layers (diel2, diel3) up to the thick metal plate (met2) in at least a zone around the first slot (18) and smoothing and cleaning the bare metal surface to make it as a flange ready to be joined with the rectangular waveguide (20).

6. Manufacturing method in accordance with one of the preceding claim, **characterised in that** includes the additional step of:
- milling the first dielectric layer (diel1) opening windows for the insertion of bare microwave chips (11) of said planar circuit metallized on the rear side;
- fixing said microwave chips (11) to the thick metal plate (met2) constituting a heat dissipating support;
- bonding said microwave chips (11) to relevant points of the metallic layout (met1) on the first dielectric layer (diel1);
- optional covering the chip components (11) and relevant bonds with a protection resin.

7. Manufacturing method in accordance with one of the preceding claim, **characterised in that** includes the step of fixing a metal backshort (22) to said first dielectric substrate (diel1) to cover the last part of the microstrip (15, 16) in correspondence of the transition (18) in order to prevent the propagation on air.

8. Manufacturing method in accordance with one of the preceding claim, **characterised in that** said waveguide (20) is dug in a metal case (21) housing the printed circuit board.

9. Microstrip to waveguide transition on a printed circuit board that includes a first dielectric substrate (diel1) supporting a metallic layout (met1) belonging to a planar circuit on the front face including a microstrip (15) which has to be coupled to a waveguide (20) for transmitting/receiving a microwave signal to/from the external of the board, **characterised in that** includes:
- a metal plate (met2) having thickness such as to offer mechanical stiffness to the first dielectric substrate (diell) adherent to it, the metal plate (met2) constituting an electrical grounding plane enabling the conductive lines of said metallic layout (met1) to operate as microstrips, and further dissipating the heat of microwave components placed on it;
- a first slot (18) milled in the thick metal plate (met2) in correspondence of the end of said microstrip (15), the first slot (18) having shape and dimensions calculated to act in the desired frequency band as a transition from the electromagnetic propagation mode of the relevant microstrip (15) to the propagation mode of the waveguide (20);
- a second slot (20') milled in the end wall of the waveguide (20) to be contiguous to the first slot (18) milled in the thick metal plate (met2);
- a flange corresponding to the zone of the thick metal plate (met2) put in contact with the end of the waveguide (20);
- fastening means (17V) for fixing the end of the waveguide (20) to the flange maintaining the two slots (18, 20') aligned to complete the transition.

10. Microstrip to waveguide transition in accordance with claim 10, **characterised in that** the end of said microstrip (15) is shaped like a metal patch (16) whose dimensions are calculated to match the coupling between the end of the microstrip (15) and the slot (18) milled in the thick metal plate (met2).

11. Microstrip to waveguide transition in accordance with claim 9 or 10, **characterised in that** further includes a waveguide transformer for improving the electromagnetic energy transfer from said microstrip (15) to the waveguide (20) or vice-versa minimising the return losses, constituted of:
- an initial tract (19) of the first slot (18) having wider cross-section than the remaining part of the slot;
- the second slot (20') having either the same or wider cross-section as the initial tract (19) of the contiguous first slot (18).

12. Microstrip to waveguide transition in accordance with one of the preceding claims from 9 to 11, **characterised in that** includes:
- additional dielectric layers (diel2, diel3) supporting relevant circuit layouts or ground planes (met3, met4) stacked with said thick metal plate (met2) and the first dielectric substrate (diel1) to form a multilayer printed circuit board;
- via-hole for electrically connect relevant points of the various layouts or ground planes.

13. Microstrip to waveguide transition in accordance with one of the preceding claim from 9 to 12, **characterised in that** includes a metal backshort (22) fixed to said first dielectric substrate (diel1) to cover the last part of the microstrip (15, 16) in correspondence of the transition (18) in order to prevent the propagation on air.

14. Microstrip to waveguide transition in accordance with one of the preceding claim from 9 to 13, **characterised in that** the thickness of said metallic layout (met1) belonging to a planar circuit is around 18 µm and the thickness of said metallic plate (met2) having thickness such as to offer mechanical stiffness to the first dielectric substrate is around 1 mm.

15. Microstrip to waveguide transition in accordance with claim 9, **characterised in that** said fastening means are screws (17V).
